# EUROPEAN PATENT APPLICATION

(11) **EP 2 133 306 A1**
(43) Date of publication of application: **16.12.2009**
(21) Application number: 08158181.1
(22) Date of filing: 13.06.2008
(51) Int. Cl.: B81B 3/00, F03G 7/00, B81C 1/00, B81C 5/00, B41M 3/00

(54) **Polymer micro-actuators sensitive to one or more inputs**

(71) Applicant: Stichting Dutch Polymer Institute, 5612 AB Eindhoven (NL)
(72) Inventor: The designation of the inventor has not yet been filed
(74) Representative: Damen, Daniel Martijn

(57) **Abstract**

The present invention relates to a micromechanical element comprising an actuator that is patterned on a substrate wherein the actuator comprises at least two responsive actuator materials that respond either to different stimuli or that respond differently to the same stimulus. The invention further relates to a device comprising said micromechanical element and the use of said micromechanical element in lifestyle, health care and technical applications. Also the method of making said micromechanical element is within the scope of the present invention.

## Description

### FIELD OF THE INVENTION

The present invention relates to micromechanical systems, in particular to polymer micro-actuators. More in particular the present invention relates to a micromechanical element comprising actuators patterned on a substrate, wherein the actuators comprise at least two responsive actuator materials that respond either to different stimuli or that respond differently to the same stimulus. A further subject of the present invention is a method for producing such a micromechanical element.

### BACKGROUND OF THE INVENTION

In micro-mechanical systems (MEMS), actuators are used to generate controlled motion in order to obtain the functionality desired for the device. The devices typically find their application in small-sized products as microfluidics, biosensors, transducers, motion sensors, etc. But presently they are also considered for large area applications such as lighting, housings of consumer products, lifestyle products as adjustable walls, etc. Actuation inputs for these actuators can be electrical fields, light, chemical stimuli or temperature. In any case, the actuation output is a mechanical deformation. Currently, the process of making micro-sized actuators is complex and expensive.

The typical fabrication process uses lithography or micro contact printing. These are multistep batch-processes typically meant for small surfaces and are not compatible with roll-to-roll continuous processing.

The usual fabrication processes like lithography or micro-contact printing use physical masks or moulds. This limits the flexibility of the device design as it requires the fabrication of a new mask or mould for any change in the design.

In many MEMS applications, out-of-plane bending is the desired actuator motion. Fabrication of out-of-plane bending actuators usually involves the deposition of a number of layers in the thickness of the device, each of these layers requiring high-accuracy in-plane structuring.

The current fabrication processes for micro-actuators makes it complex to integrate multiple actuators addressable with a different stimulus into a single layer. Therefore, global fields can not be used as a stimulus and all stimuli have to be localized, adding complexity to the device design.

Due to these constraints, there is a limit in design freedom and the fabrication of MEMS is expensive.

Traditionally, MEMS actuators are fabricated using top-down techniques, in particular using lithography, often in combination with a wet or dry etching step. The typical motion of these actuators is bending, which is usually achieved by making a bi-layer structure. Bottom-up fabrication techniques also exist, for example soft-lithography. Using a mould, the material is structured and fixed in-situ, after which the mould is removed. Patterns of actuators on substrates produced by soft-lithography are e.g. taught in Buguin et al. 2006 (J. Am. Chem. Soc., 128, 1088-1089). When multiple actuators in the same device need to be individually controlled, this is usually done using localized actuation. In case electric fields are the actuator input, this is achieved by patterning the electrodes on top or below the actuator. Because lithography is the typical fabrication route, this will typically result in systems with a large number of layers. Systems with multiple actuators that are less complex and easy to fabricate and control are desired.

### SUMMARY OF THE INVENTION

The present invention relates to a micromechanical element comprising an actuator that is patterned on a substrate, wherein the actuator comprises at least two responsive actuator materials that respond either to different stimuli or that respond differently to the same stimulus wherein the response of said responsive actuator materials leads to actuator motion. In one embodiment, the actuator comprises a polymer with liquid crystalline units in the main-chain, side-chain or as part of the polymer network. Preferably, the actuator motion is out-of-plane bending and the actuator is patterned in-plane on said substrate. In preferred embodiments, the responsive actuator material is responsive to a stimulus selected from the group comprising temperature, radiation, an electric field, a magnetic field and a chemical stimulus.

Also within the scope of the present invention is a device comprising the micromechanical element of the present invention.

Furthermore, the present invention relates to a method for making the substrate according to the present invention comprising a step of inkjet printing of at least two actuator materials to a substrate.

In one embodiment, the present invention relates to a method for making the micromechanical element according to the present invention, comprising the steps of:
(i) providing a substrate,
(ii) adding a patterned sacrificial layer or a pattern of sticking and non-sticking surfaces to the substrate by patterning techniques selected from the group of lithography, microcontact printing, inkjet printing and lift-off techniques,
(iii) adding a pattern of at least two monomeric actuator materials by inkjet printing, wherein the at least two actuator materials respond either to different stimuli or respond differently to the same stimulus and wherein the response of said responsive - actuator materials leads to actuator motion,
(iv) polymerizing said monomeric actuator materials, and
(v) dissolving the patterned sacrificial layer or releasing the actuator material from the non-sticking surfaces, thereby creating freestanding actuators.

The present invention also relates to the use of a micromechanical element according to the present invention or a device according to the present invention for lab-on-a-chip applications, for lifestyle applications, for applications in the area of health care and for applications in the area of lighting.

### BRIEF DESCRIPTION OF THE DRAWINGS

Fig. 1: Example of a device-layout of a micromechanical element showing actuators with two different responsive materials (a and b) sensitive to two different actuation inputs.
Fig. 2: Example of a micromechanical element with an actuator patterned on a substrate, wherein the actuator comprises two responsive materials (responsive material 1 is designated "a" and responsive material 2 is designated "b" in the Figure).
Fig. 3: Example of a micromechanical element with an actuator patterned on a substrate, wherein the two responsive materials (responsive material 1 is designated "a" and responsive material 2 is designated "b" in the Figure) are patterned on a non-responsive actuator material.
Fig. 4: Example of a micromechanical element with an actuator patterned on a substrate, wherein the actuator comprises a gradient of two responsive materials (responsive material 1 is designated "a" and responsive material 2 is designated "b" in the Figure).
Fig. 5: Example of processing steps for the manufacturing of freestanding actuators. A polyvinyl alcohol release layer is patterned using the lift-off process (steps a - c). A thin alignment layer is coated over the substrate (d.). The LC-monomers are locally deposited using inkjetting, using two different inks, followed by a polymerization step (e.) Finally, the polyvinyl alcohol is dissolved to create freestanding actuators (f).
Fig. 6: Scanning electron microscope (SEM) image of a cross-section of a liquid crystal network actuator with a splayed alignment made using the method described here. In this case, the polyvinyl alcohol layer was still present underneath the actuator.
Fig. 7: Inkjet printed flaps of liquid crystal networks before release from the substrate. The edge of the patterned polyvinylalcohol layer is visible (a.). The flaps have a regular molecular alignment, as is visible in the crossed-polar images (b. and c.).
Fig. 8: Motion of inkjet printed actuators in water upon UV illumination.
Fig. 9: Responsive materials with different actuation modes locally applied by inkjetting on flexible slab. When the responsive material contracts, the MEMS element bends. Bending is for instance controlled by light exposure with different wavelengths. In the embodiment of this Figure the two actuating materials are applied on top of a neutral film. For the operation of this construct uni-axially aligned actuating materials are preferred.
Fig. 10: Inkjet printed flaps of 2 discrete actuator materials (containing disperse red acrylate 1 dye and A3MA) before release from the substrate.
Fig. 11: Inkjet printed flaps with a gradient of 2 actuator materials (containing disperse red acrylate 1 dye and A3MA) before release from the substrate.
Figs. 12 to 18 illustrate various exemplary dyes that have the potential to be used as light-driven liquid crystal network actuators.

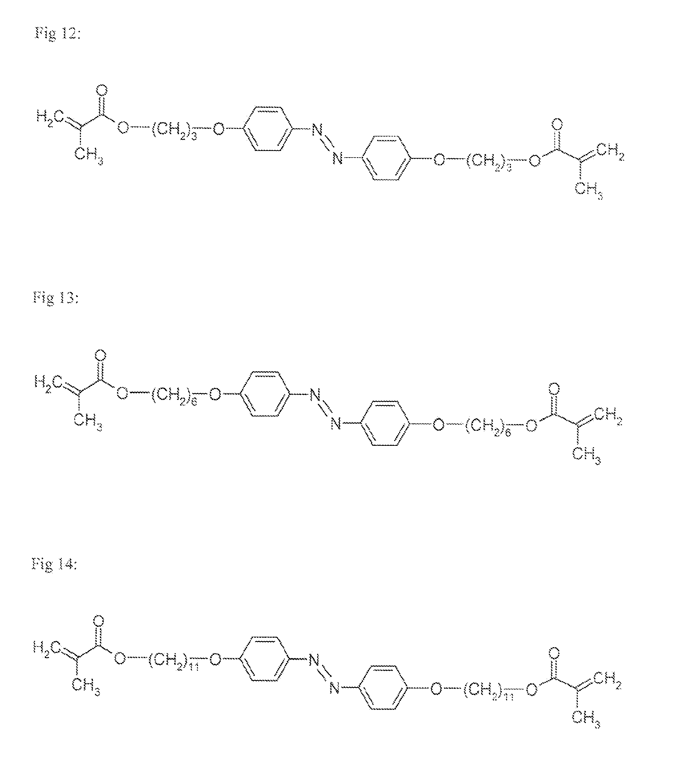

Fig. 12: A3MA. This dye has a peak absorption at 361 nm.
Fig. 13: A6MA.
Fig. 14: A11MA.

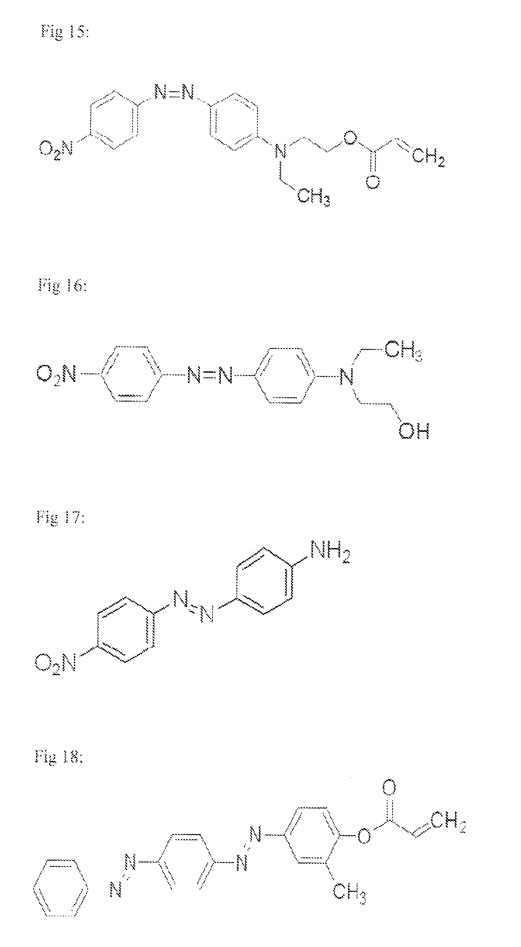

Fig. 15: Disperse red 1 acrylate (DRA). This dye has a peak absorption at 492 nm.
Fig. 16: Disperse red 1. This dye has a peak absorption at 502 nm.
Fig. 17: Disperse orange 3. This dye has a peak absorption at 443 nm.
Fig. 18: Disperse yellow 7 acrylate.

### DETAILED DESCRIPTION OF EMBODIMENTS

The present invention relates to a micromechanical element comprising an actuator that is patterned on a substrate, wherein the actuator comprises at least two responsive actuator materials that respond either to different stimuli or that respond differently to the same stimulus and wherein the response of said responsive actuator materials leads to actuator motion.

A micromechanical element in the context of the present invention is a micromechanical system or a part thereof comprising one or more actuators attached to a substrate. An actuator in this context generates controlled motion by self-deformation, e.g. bending, upon an external or internal stimulus.

In a preferred embodiment, the at least two responsive actuator materials respond differently to the same stimulus, e.g. respond to light of different wavelengths.

Preferably, the actuator is obtainable by polymerization of either a monomer or a low-molecular weight polymer.

In one embodiment, the actuator comprises a polymer with liquid crystalline (LC) units in the main-chain, side-chain or as part of the polymer network (liquid crystal network (LCN)).

The actuator motion may be out-of-plane bending. The actuator may be patterned in-plane on said substrate. Preferably, the actuator motion is out-of-plane bending and the actuator is patterned in-plane on said substrate.

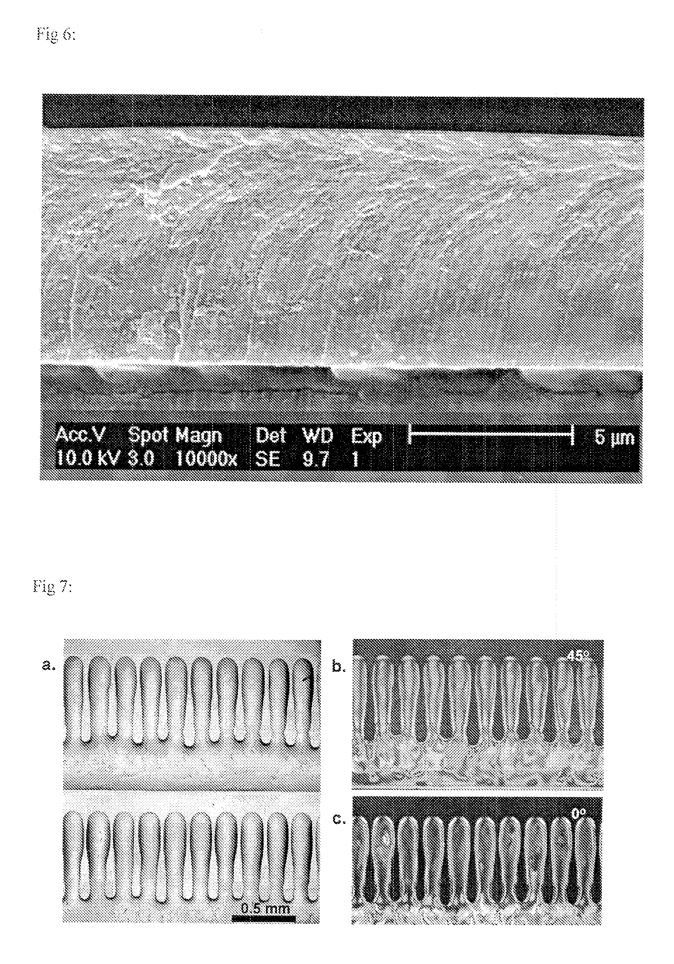

When bending is the desired actuator motion, a gradient in the molecular director may be created such that upward bending is achieved. Two configurations for bending are the splay and the twisted alignment. A splayed alignment can be obtained by preparing the substrate with a thin polyimide alignment layer and adding a small amount of planarization surfactant. The polyimide layer preferably is a homeotropic aligning polyimide that is mechanically rubbed to align the molecular director of the LC with a controlled deviation from the substrate normal. At the air interface, the planarization surfactant suppresses homeotropic alignment and a homogenous splay is obtained from the substrate to the air interface. Fig. 6 demonstrates the splayed alignment of the responsive material on such a substrate.

A twisted alignment can be obtained by preparing the substrate with a thin polyimide alignment layer and adding a small amount of chiral dopant. The polyimide layer preferably is a planar aligning polyimide that is mechanically rubbed to align the molecular director of the LC parallel to the substrate. The chiral dopant is added in such a quantity that a twist of substantially 90° in the molecular director through the thickness is achieved. Substantially 90° in this context means 90° +/- 20°.

The actuators may also be thin film actuators having a thickness of from 0.1 µm to 100 µm, preferably in the range of from 0.5 µm to 20 µm. Thin film actuators in the context of the present invention are a class of actuators based on depositioning and modifying of thin films.

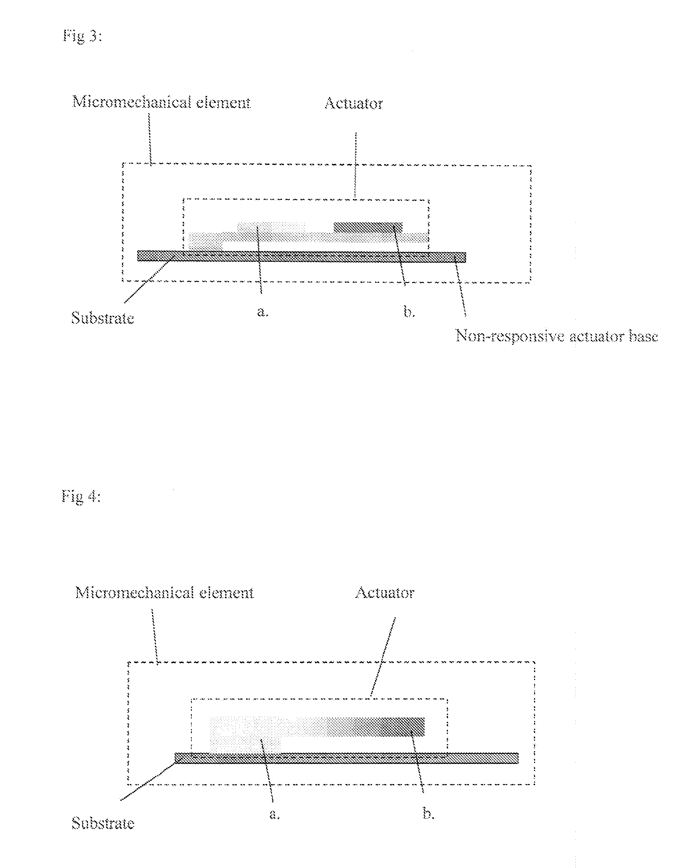

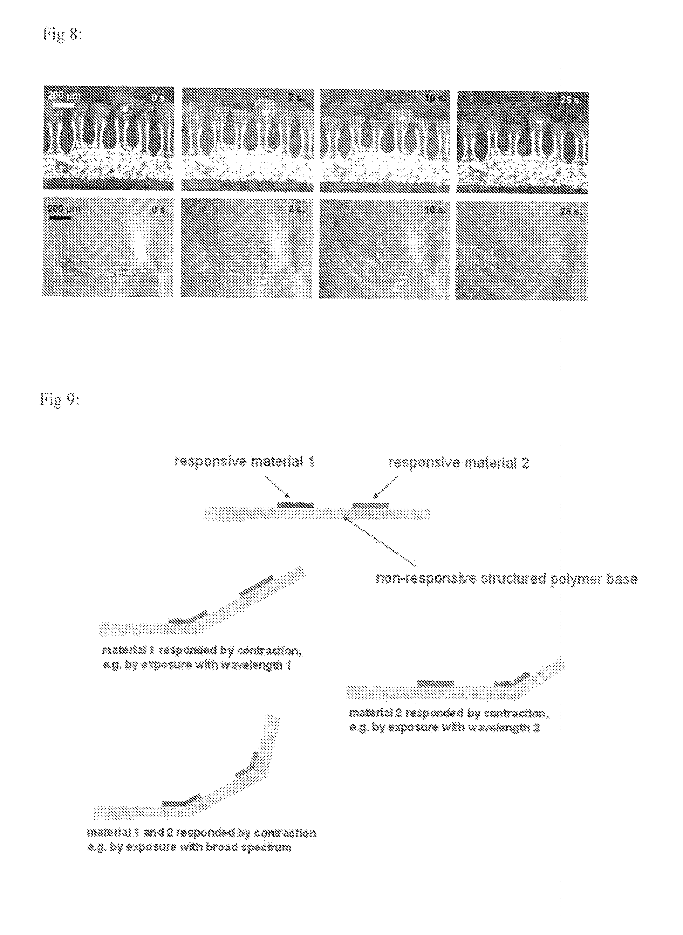

The actuators may also be constructed from an as such non-responsive slab (i.e. a non-responsive actuator base) on which the responsive materials are printed as suggested in Figs. 4 and 9. In this case the molecular alignment in the responsive elements can be simply uniaxial. Contraction of either of the elements along the long axis of the construct will result in a localized bending motion of the construct. The terms "non-responsive actuator base", "non-responsive slab" and "non-responsive polymer base" are used synonymously herein.

According to a preferred embodiment, the responsive materials are capable to deform upon application of one or more external stimuli. Therefore, in this embodiment the actuators may preferably be capable to deform upon application of one or more external stimuli.

According to another embodiment, the actuators are capable to deform using internal stimuli. This may for example in a particular embodiment be achieved using an oscillatory Belousov-Zhabotinsky reaction immobilized on a gel as described by Yashin et al. 2006 (Science 314, 798).

In some embodiments of the present invention, the actuators are located in the same layer. Preferably, the layer is a single layer. The substrate according to the present invention may also be a flexible substrate.

A substrate in the context of the present invention may be any substrate suitable for the use in micromechanical systems and elements. In particular the substrate should be suitable for the attachment of the actuators or actuator slabs according to the present invention. Preferably the substrates of the micromechanical elements of the present invention may be selected from the group comprising polymer, glass, silicon, cellulose-based or non-woven textiles, most preferably polymer or glass.

The responsive material layer has in some embodiments an internal gradient in material properties or material composition. Such a gradient may for example be over the cross-section of the thin film or may be in lateral direction. The gradient may in particular embodiments be a gradient in elastic modulus, a gradient in crosslink density or a gradient in the concentration of a component, e.g. a gradient in the concentration of a dye (particularly an azobenzene dye) or antidromic gradients of two dyes. Preferably, the actuator has a gradient in either chemical composition, molecular orientation, thickness, or UV-absorption.

In preferred embodiments, the responsive actuator material is responsive to a stimulus selected from the group comprising temperature, radiation, an electric field, a magnetic field and a chemical stimulus. The responsive actuator material may for example be responsive to changes of the stimulus, e.g. changes in temperature or field. The term "stimulus" is used synonymously with the term "actuation input" herein.

In this context, an electric field may have field strengths in the range of from about between 1 V/um and 1000 V/µm, preferably between about 5 V/µm and 100 V/µm. The magnetic field may have magnetic field strengths in the range of from about 0.01 T to 50 T, preferably between about 0.01 T and 1 T.

A chemical stimulus in this context may for example be a change of liquid, e.g. from water to an alcohol. It may also be a particular chemical or chemical composition such as an acid or a base, e.g. a change ion pH. It may even be a biological molecule or composition such as a protein or a DNA fragment.

In preferred embodiments, the responsive actuator material is responsive to light of a certain wavelength. In particular embodiments, light of two wavelengths may be used, wherein the two responsive materials react on a different wavelength regime. Also the combination of two or more responsive materials that are responsive to different kinds of stimuli is possible, e.g. one responsive material is responsive to light, e.g. of a certain wavelength and the other responsive material is responsive to another stimulus, e.g. pH or temperature.

The responsive material according to the present invention is a responsive composition or compound or comprises a responsive composition or compound. Responsive herein means responsive to the external or internal stimuli.

The responsive actuator material may comprise one or more dyes. Fig. 12 to 18 illustrate various exemplary dyes that have the potential to be used in responsive materials, e.g. as light-driven liquid crystal network actuators. Preferably the actuator material comprises an azobenzene dye. More preferably, the responsive actuator material comprises an A3MA dye (see Fig. 12). The peak absorption of A3MA dye is at around 360 nm. The responsive actuator material in some embodiments also comprises a disperse red acrylate dye (DRA; see Fig. 15). The peak absorption of DRA is at around 492 nm. In some embodiments the actuator material comprises a least two different azobenzene dyes with different absorption bands. The actuator may also comprise 3, 4, 5, 6 or more different azobenzene dyes. The dyes may e.g. be selected from the group of A3MA, A6MA, A11MA, disperse red 1 acrylate, disperse red 1, disperse orange 3 and disperse yellow 7.

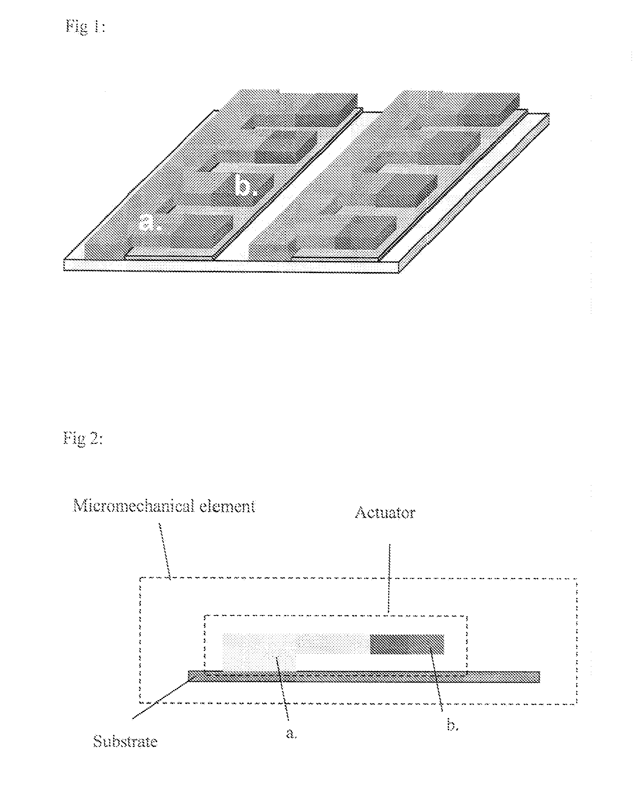

The micromechanical element in Fig. 1 may comprise two different LCN light-responsive actuator materials (designated a and b). For example, an actuator is made of one part that comprises the DRA dye and another part that comprises the A3MA dye, separate actuation of parts a and b is possible simply by changing the wavelength of the light.

The terms "responsive material" and "responsive actuator material" are used synonymously herein.

The responsive material is in some embodiments incorporated in the polymer matrix of the actuator.

The micromechanical element according to the present invention may in a particular embodiment comprise one part that comprises a first responsive actuator material and comprise another part that comprises a second responsive actuator material.

In a preferred embodiment, the two or more actuating elements of the micromechanical element comprise the same materials but with different concentrations of the bending-inducing molecules. In the case of the photo-responsive construct this may be different dye concentrations which will provide a different response to an equal light dose.

In a further preferred embodiment the two or more actuating elements of the micromechanical element comprise the same materials but with different orientation of the bending-inducing molecules. In the case of the photo-responsive construct this may be different dye orientation which will provide a different response to an equal light dose. For instance one area may bend upwards and the other downwards.

In preferred embodiments, the actuator is a freestanding actuator that is only partially attached to the substrate.

In a preferred embodiment, the actuator does not comprise a polymer gel.

Also within the scope of the present invention is a device comprising the micromechanical element according to the present invention.

Furthermore, the present invention relates to a method for making the micromechanical element according to the present invention comprising a step of inkjet printing of at least two actuator materials to a substrate.

Inkjet printing is less material intensive and thus less cost intensive than top-down techniques which are material inefficient, whereas inkjet printing only deposits the necessary material. Furthermore, when using top-down techniques it is complicated to vary the actuator composition in-plane. Top down processes are poorly compatible with roll-to-roll processing as they are batch processes or not suitable for flexible substrates. With most bottom-up processes, complex device designs incorporating a number of structured layers are hard to fabricate. These drawbacks of other methods are overcome by the inkjet printing methods according to the present invention.

Inkjet printing has a number of advantages: It can be used on both stiff and flexible substrate, allowing for example roll-to-roll processing. It is flexible for changes in design of substrates such as micro-devices, as it only needs a new digital print file for each different substrate rather than a new physical mould or mask. Using a number of inks, similar to color-printing, different actuator materials can be applied to the same layer, all in the same processing step. This makes it possible to produce actuators responding to different actuation inputs in the same layer. Addressing these actuators may be done using global fields rather than with local addressing. An example of such an actuator is given in Fig. 1. This actuator comprises two materials, a and b, which respond to different inputs. Global fields can be applied to address them individually, eliminating the need to localize the actuation inputs.

When reactive liquid crystal monomers are used as the actuator material, a bending actuator can be created using a single layer rather than through a bi-layer structure. Alternatively, a bending actuator can be obtained from a gradient in the input, such as a gradient in radiation, magnetic field, temperature, electric or chemical stimulus. Thus, only a single step may in some embodiments structure the actuator.

In one particular embodiment, the present invention relates to a method for making the micromechanical element according to the present invention, comprising the steps of:
(i) providing a substrate (as a base body for the micromechanical element),
(ii) adding a pattern of a non-responsive structured polymer base by patterning techniques selected from the group of lithography, microcontact printing, inkjet printing and lift-off techniques, and
(iii) adding a pattern of at least two monomeric actuator materials by inkjet printing to said base added in step (ii), wherein the at least two responsive materials respond either to different stimuli or respond differently to the same stimulus and wherein the response of said responsive actuator materials leads to motion of the base. Thus, in such an embodiment responsive actuator materials may be printed locally on small structured polymer slabs (i.e. a non-responsive actuator base) created by e.g. inkjet printing. This is further illustrated in appended Figs. 4 and 9.

Also within the scope of the present invention is a method for making a micromechanical element according to the present invention, comprising the steps of:
(i) providing a said substrate,
(ii) adding a patterned sacrificial layer or a pattern of sticking and non-sticking surfaces to said substrate by patterning techniques selected from the group of lithography, microcontact printing, inkjet printing and lift-off techniques,
(iii) adding a pattern of at least two monomeric responsive actuator materials by inkjet printing, wherein the at least two responsive actuator materials respond either to different stimuli or respond differently to the same stimulus and wherein the response of said responsive actuator materials leads to actuator motion,
(iv) polymerizing said monomeric actuator materials, and
(v) dissolving the patterned sacrificial layer or the releasing the actuator material from the non-sticking surfaces, thereby creating freestanding actuators.

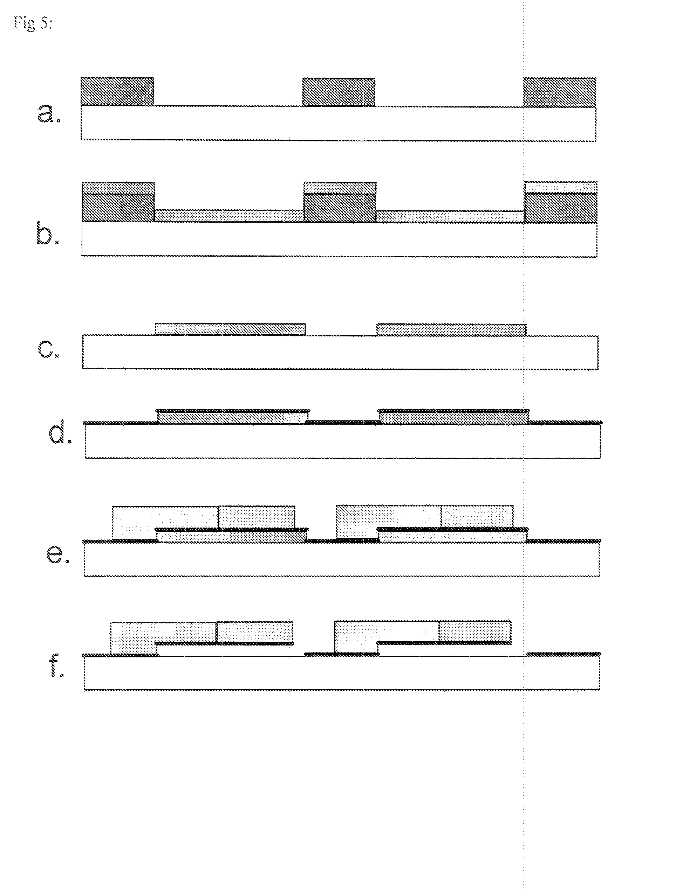

Preferably, the method of making the substrate comprises the steps of:
(i) providing a substrate,
(ii) adding the negative image of the pattern to the substrate by applying a lift-off photo-resist,
(iii) adding a sacrificial layer to said base body of the substrate,
(iv) dissolving the lift-off resist such that only the sacrificial layer pattern on the substrate remains,
(v) optionally adding an alignment layer to said basic-body of the substrate with the sacrificial layer and/or mechanically rubbing the surface,
(vi) adding a pattern of at least two monomeric actuator materials by inkjet printing,
(vii) polymerizing said monomeric actuator materials, and
(viii) dissolving the sacrificial layer, thereby creating freestanding actuators. Preferably, the sacrificial layer is a of polyvinyl alcohol layer or comprises polyvinyl alcohol. An example of such an embodiment is illustrated in appended Fig. 5.

In some embodiments the sacrificial layer is directly patterned using a photo-resist material, instead of using the more complex lift-off process described above. In that case, the above steps (iii) and (iv) of the method are not mandatory.

In the case of liquid crystal actuators, an additional layer may be required to achieve the proper molecular alignment within the actuator. This alignment layer is preferably very thin (in the range of from about 10 to 500 nm, preferably around 100 nm) and can thus usually be applied as a coating over the whole substrate, e.g. by spin coating. The alignment layer may comprise, *inter alia*, polyimide, e.g. obtained from Nissan Chemical Industries Ltd, grade 5300.

In an alternative embodiment, the polyvinyl alcohol may be structurally deposited from a diluted solution by inkjet printing.

In some embodiments, the method employs actuator materials comprising monomers or low-molecular weight polymers that are in the liquid phase at or close to room temperature. Alternatively, they can be dissolved using appropriate solvents. These materials can form thin film actuators capable to deform upon application of external stimuli. Using an inkjet printer, small drops of the actuator materials are deposited on the desired location on the prepared substrate. The inkjet head and substrate may be heated to achieve the desired properties of the ink and control the evaporation of solvents in the ink during and after the deposition. Where a line or a surface is desired, the spacing between the drops is chosen such that an uninterrupted structure is produced. Subsequently, the materials are fixed by a polymerization step. Different inks may be used to create actuators having different sensitivity to various actuator inputs in a single plane.

In a preferred embodiment of the method, the at least two responsive actuator materials respond differently to the same stimulus, e.g. respond to light of different wavelengths.

In a particular embodiment of the present invention, the actuator material comprises a polymer with liquid crystalline units in the main-chain, side-chain or as part of the polymer network. The lift-off photo-resist may be for example those described in Adda-Mensah et al. 2007 (J. Micromech. Microeng. 17, N41-N46), or the MaN or MaP resists from Micro Resist Technologies GmbH, Germany, or the LOR/PMGI resists from MicroChem. Other lift-off photo-resists may be based on novolacs or may comprise polyvinyl phenol that is provided with a photo-acid generator that makes the material soluble upon exposure with UV or blue light. In the context of the present invention this means the film becomes soluble as soon as the monomer of the polymer micro-slabs are being photocrosslinked.

Yet another lift-off material may comprise polyvinylpyrollidone which on itself is water soluble and can be structured e.g. by inkjet printing.

Yet another class of lift-off materials are those that exhibit a discrete ceiling temperature above which they decompose into volatile materials. This prevents wet processing and sticking phenomena. Well-known materials with an easy accessible ceiling temperature are polyvinylalcohol and poly-α-methylstyrene.

In some embodiments of the method according to the present invention, the prepared substrate is positioned in the inkjet printer and the actuator materials are printed, either successively or (quasi-)simultaneously depending on the printer design. In some cases, the reactive monomers are liquid within the temperature range of the heated cartridge. Alternatively, the monomers can be dissolved in an appropriate solvent. The substrate is heated to evaporate the solvent and achieve the proper alignment of the LC monomers. Subsequently, the LC reactive monomers are polymerized using a photo-polymerization. Inkjetted flaps of a single material are shown in Fig. 7. Finally, the actuators are released from the substrate (illustrated in appended Fig. 5f). For a full release, it may be necessary to break the polyimide layer using a very short ultrasound bath. The motion of the actuators upon exposure with light is demonstrated in Fig. 8.

The present invention also relates to the use of a substrate according to the present invention or a device according to the present invention for lab-on-a-chip applications, for lifestyle applications, for applications in the area of health care and for applications in the area of lighting. In particular embodiments, the substrate may be used for directing, mixing or transporting fluids in lab-on-a-chip applications. Particular embodiments of the use of the substrate in lighting applications comprise the use in shutter system as described in WO 2005/076246, e.g. a mechanical shutter with polymerized liquid crystal layer.

The micromechanical elements and methods of the present invention are in no way limited to sub-millimeter structures.

The following examples are illustrative examples which do not limit the scope of the present invention.

### EXAMPLES:

### Example 1: Manufacturing of a micromechanical element with free-standing liquid crystal actuators with two different actuator modes

In appended Fig. 5, an example of the manufacturing of a substrate with free-standing liquid crystal actuators is illustrated. The manufacturing process comprises several steps:
1. The negative image of the latter actuator pattern is added to the substrate by applying a lift-off photo-resist (Fig. 5a). The lift off photo-resist has a thickness of at least 1 µm but preferably 3 µm or more.
2. A sacrificial layer of polyvinyl alcohol with a thickness of about 1 µm is added by spincoating from an aqueous solution and evaporating the water (Fig. 5b).
3. The lift-off resist is dissolved in a solvent that poorly dissolves the polyvinyl alcohol, such as acetone, so that only the sacrificial layer pattern on the substrate remains (Fig. 5c).
4. An alignment layer is coated over the substrate (Fig. 5d) to a thickness of about 100 nm. The alignment layer is mechanically rubbed with a velvet cloth to obtain the desired molecular alignment with respect to the substrate normal.
5. The pattern of part of the actuator is added by inkjet printing using one of the two monomeric liquid crystal actuator materials, one comprising A3MA, the other comprising DRA (Fig. 5e). The inkjetted drops are spaced in such a way that an continuous actuator structure is obtained. By decreasing the spacing of the inkjet drops, the thickness of the actuators can be increased. The monomeric actuator material is polymerized in the nematic phase of the monomeric liquid crystal actuator material using a photopolymerization.
6. The pattern of the remaining part of the actuator is added by inkjet printing of the other monomeric liquid crystal actuator material. The monomeric actuator material is polymerized in the nematic phase of the monomeric liquid crystal actuator material using a photopolymerization.
7. The sacrificial layer is dissolved, thereby freestanding actuators are created (Fig. 5f).

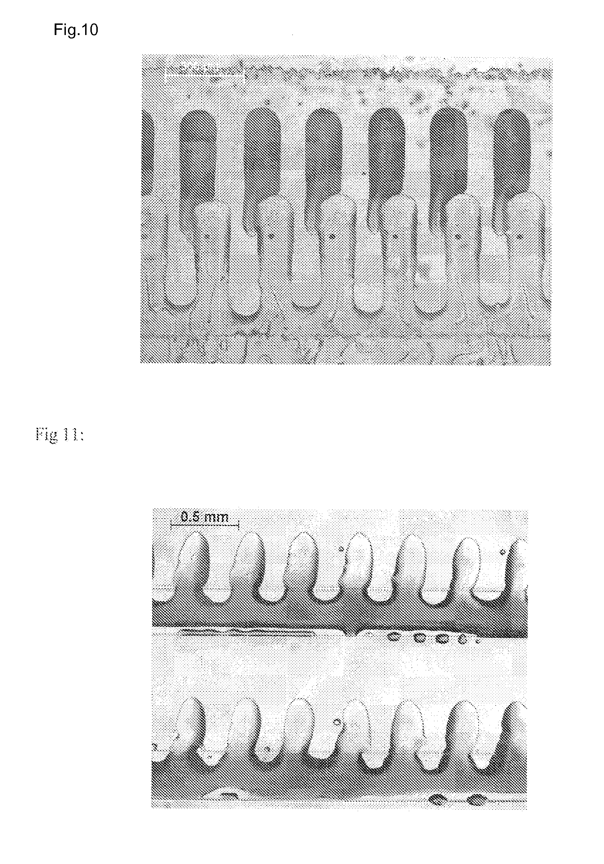

Appended Fig. 6 shows the cross-section of a liquid crystal network actuator produced following the above protocol steps 1 - 6. Fig. 7 illustrates the molecular alignment of inkjet printed flaps (actuators) of liquid crystal networks after step 5. Fig. 10 shows the top view of the actuators before step 7. Fig. 8 shows the motion of the inkjet printed actuators in water upon UV illumination after completing the above process.

### Example 2: Manufacturing of a micromechanical element with free-standing liquid crystal actuators with a gradient of different actuator modes

Following the steps 1 - 4 as described before and as illustrated by the process in appended Fig. 5:
5. The pattern of part of the actuator is added by inkjet printing using two monomeric liquid crystal actuator materials, one comprising A3MA, the other comprising DRA (Fig. 5e). The inkjetted drops are spaced in such a way that an integer actuator structure is obtained. The pattern of the two different monomeric materials is printed in such a way that an area is created where there is an in-plane gradient in material composition from material one to material two.
6. The monomeric actuator materials are polymerized in the nematic phase of the monomeric liquid crystal actuator material using a photopolymerization.
7. The sacrificial layer is dissolved, thereby freestanding actuators are created (Fig. 5f).

Appended Fig. 11 shows a microscopy image of actuators before removal of the sacrificial layer in step 7.

### Example 3: Responsive materials with different actuator modes on a carrier structure

In appended Fig. 9, an alternative example of the manufacturing of a micromechanical element with free-standing actuators, i.e. a MEMS, is illustrated. The manufacturing process comprises several steps:
1. A desired non responsive structured polymer base is added to the substrate using techniques selected from the group of lithography, microcontact printing, inkjet printing and lift-off techniques. The polymer base has a low mechanical resistance to bending in at least on direction.
2. A pattern of at two monomeric actuator materials (one comprising A3MA, the other comprising DRA) by inkjet printing to the actuators added in step 1.
3. The monomeric actuator materials are polymerized in the nematic phase of the monomeric liquid crystal actuator material using a photo-polymerization.

Upon illumination with light of 360 nm wavelength, the responsive material comprising A3MA contracts and the non responsive actuator base bends, upon irradiation at 492 nm, the other responsive material comprising DRA contracts and the non responsive actuator base bends at another position. Upon illumination at both wavelengths, both responsive materials contract and bending at both positions observed.

## Claims

1. A micromechanical element comprising an actuator that is patterned on a substrate, wherein the actuator comprises at least two responsive actuator materials that respond either to different stimuli or that respond differently to the same stimulus and wherein the response of said responsive actuator materials leads to actuator motion.

2. Micromechanical element according to claim 1, wherein the actuator has a gradient in either chemical composition, molecular orientation, thickness, or UV-absorption.

3. Micromechanical element according to claim 1 or 2, wherein the actuator comprises a polymer with liquid crystalline units in the main-chain, side-chain or as part of the polymer network.

4. Micromechanical element according to claims 1 to 3, wherein the actuator motion is out-of-plane bending and the actuator is patterned in-plane on said substrate.

5. Micromechanical element according to claims 1 to 4, wherein the actuators are capable to deform upon application of one or more external stimuli or are capable to deform using internal stimuli.

6. Micromechanical element according to claims 1 to 5, wherein the responsive actuator material is responsive to a stimulus selected from the group comprising temperature, radiation, an electric field, a magnetic field, a chemical stimulus light of a certain wavelength.

7. Micromechanical element according to claims 1 to 6, wherein the responsive material comprises a least two different azobenzene dyes with different absorption bands.

8. Micromechanical element according to claims 1 to 7, wherein the responsive material is incorporated in the polymer matrix of the actuator.

9. Micromechanical element according to claims 1 to 8, comprising one part that comprises a first responsive actuator material and comprising another part that comprises a second responsive actuator material.

10. Micromechanical element according to claims 1 to 9, wherein the actuator is a freestanding actuator that is only partially attached to the substrate.

11. Device comprising a micromechanical element according to claims 1 to 10.

12. Method for making the micromechanical element of claims 1 to 10, comprising the steps of:
(i) providing a substrate,
(ii) adding a pattern of a non-responsive structured polymer base by patterning techniques selected from the group of lithography, microcontact printing, inkjet printing and lift-off techniques,
(iii) adding a pattern of at least two monomeric actuator materials by inkjet printing to said base added in step ii., wherein the at least two actuator materials respond either to different stimuli or respond differently to the same stimulus and wherein the response of said responsive actuator materials leads to motion of the base.

13. Method for making the micromechanical element of claims 1 to 10, comprising the steps of:
(i) providing a substrate,
(ii) adding a patterned sacrificial layer or a pattern of sticking and non-sticking surfaces by patterning techniques selected from the group of lithography, microcontact printing, inkjet printing and lift-off techniques,
(iii) adding a pattern of at least two monomeric actuator materials by inkjet printing, wherein the at least two actuator materials respond either to different stimuli or respond differently to the same stimulus and wherein the response of said responsive actuator materials leads to actuator motion;
(iv) polymerizing said monomeric actuator materials, and
(v) dissolving the patterned sacrificial layer or releasing the actuator material from the non-sticking surfaces, thereby creating freestanding actuators.

14. Method of making a micromechanical element according to claim 13, comprising the steps of:
(i) providing a substrate,
(ii) adding the negative image of the pattern to the base body of the substrate by applying a lift-off photo-resist,
(iii) adding a sacrificial layer to said substrate,
(iv) dissolving the lift-off resist such that only the sacrificial layer pattern on the substrate remains,
(v) optionally adding an alignment layer to said substrate with the sacrificial layer and/or mechanically rubbing the surface,
(vi) adding a pattern of at least two monomeric actuator materials by inkjet printing,
(vii) polymerizing said monomeric actuator materials, and
(viii) dissolving the sacrificial layer, thereby creating freestanding actuators.

15. Use of a micromechanical element according to claims 1 to 10 or a device according to claim 11 for lab-on-a-chip applications, lifestyle applications, applications in the area of health care and applications in the area of lighting.
